# DEMANDE DE BREVET EUROPEEN

(11) **EP 2 320 463 A1**
(43) Date de publication de la demande: **11.05.2011**
(21) Numéro de dépôt: 10190547.9
(22) Date de dépôt: 09.11.2010
(51) Int. Cl.: H01L 27/146

(54) **Procédé de formation d'un capteur d'images éclairé par la face arrière**

(30) Priorité: 10.11.2009 FR 0957950
(71) Demandeur: STmicroelectronics SA, 92120 Montrouge (FR); STMicroelectronics (Crolles 2) SAS, 38920 Crolles (FR)
(72) Inventeur: Marty, Michel, 38760 Saint Paul De Varces (FR); Leverd, François, 38330 Saint Ismier (FR)
(74) Mandataire: de Beaumont, Michel

(57) **Abrégé**

L'invention concerne un procédé de fabrication d'un capteur d'images éclairé par la face arrière, comprenant les étapes suivantes :
(a) former, dans et sur une couche de silicium (14) de type SOI, des composants de capture et de transfert de porteurs photo-générés (24, 26, 27) et des régions d'isolement (28) ;
(b) former un empilement de niveaux d'interconnexion (16) sur la couche de silicium (14) et fixer, sur l'empilement d'interconnexion, une poignée semiconductrice (22) ;
(c) éliminer le support semiconducteur (10) ;
(d) former, dans la couche isolante (12) et la couche de silicium (14), des tranchées (42, 44) atteignant les régions d'isolement ;
(e) déposer une couche de silicium amorphe (46) plus fortement dopée que la couche de silicium (14) sur les parois et le fond des tranchées et faire cristalliser ladite couche de silicium amorphe (48) ; et
(f) remplir les tranchées d'un matériau réfléchissant (50).

## Description

### Domaine de l'invention

La présente invention concerne un procédé de formation d'un capteur d'images éclairé par la face arrière comprenant des pixels isolés les uns des autres.

### Exposé de l'art antérieur

Les capteurs d'images éclairés par la face arrière sont de plus en plus utilisés dans les dispositifs de photodétection. Dans de tels capteurs, des pistes et vias conducteurs connectant les différents composants de photodétection sont formés du côté d'une première face d'une couche semiconductrice, le dispositif étant éclairé par une seconde face ou face arrière de cette couche. Ainsi, les pistes et vias conducteurs ne perturbent pas le passage de rayons lumineux qui génèrent des paires électrons/trous dans la couche semiconductrice.

Un capteur d'images éclairé par la face arrière est généralement formé comme suit. On part d'une structure de type semiconducteur sur isolant (SOI), c'est-à-dire une couche semiconductrice monocristalline reposant sur un support ou substrat semiconducteur avec interposition d'une couche d'oxyde. Dans et sur la couche semiconductrice sont formés des régions de capture de porteurs photo-générés et des éléments adaptés au transfert de ces porteurs, par exemple des transistors MOS, ces éléments définissant des pixels. Un empilement de niveaux d'interconnexion dans lesquels sont formés des pistes et vias conducteurs séparés par un matériau isolant est formé sur le dispositif. Les pistes et vias conducteurs permettent de connecter les différents éléments électroniques du dispositif entre eux et à des contacts extérieurs.

Ensuite, un autre substrat, généralement une plaque de semiconductrice appelée poignée, est fixé sur la portion supérieure de l'empilement d'interconnexion. Le support ou le substrat semiconducteur initial, portant la couche semiconductrice, est ensuite éliminé en utilisant la couche d'oxyde de la structure SOI comme couche d'arrêt. Ensuite, une couche antireflet, des filtres colorés et/ou des microlentilles sont formés sur la face apparente ou face arrière de la couche semiconductrice destinée à être éclairée, à l'opposé de l'empilement d'interconnexion.

Un souci permanent dans la formation de capteurs d'images éclairés par la face arrière réside dans l'isolement entre pixels d'un même capteur. En effet, des phénomènes de diaphotie peuvent intervenir entre deux pixels, que ce soit par déplacement d'un photon vers un pixel voisin (diaphotie optique) ou par déplacement d'un porteur photo-généré (électron ou trou) vers un pixel voisin (diaphotie électronique). Ces phénomènes parasites conduisent à des détections erronées.

Ainsi, un besoin existe d'un procédé de formation d'un capteur d'images éclairé par la face arrière limitant fortement ces effets parasites.

### Résumé

Un objet d'un mode de réalisation de la présente invention est de prévoir un procédé de fabrication d'un capteur d'images dans lequel les phénomènes parasites sont éliminés.

Ainsi, un mode de réalisation de la présente invention prévoit un procédé de fabrication d'un capteur d'images éclairé par la face arrière, comprenant les étapes suivante :
(a) former, dans et sur une couche de silicium s'étendant sur un support semiconducteur avec interposition d'une couche isolante, des composants électroniques de capture et de transfert de porteurs photo-générés et des régions d'isolement des composants ;
(b) former un empilement de niveaux d'interconnexion sur la couche de silicium et fixer, en surface de l'empilement d'interconnexion, une poignée semiconductrice ;
(c) éliminer le support semiconducteur ;
(d) former, dans la couche isolante et la couche de silicium, des tranchées atteignant les régions d'isolement ;
(e) déposer une couche de silicium amorphe plus fortement dopée que la couche de silicium au moins sur les parois et le fond des tranchées et faire cristalliser la couche de silicium amorphe ; et
(f) remplir les tranchées d'un matériau réfléchissant.

Selon un mode de réalisation de la présente invention, l'étape (e) est précédée d'une étape de lissage des parois des tranchées à l'aide d'une solution chimique.

Selon un mode de réalisation de la présente invention, l'étape (d) est précédée d'une étape de formation d'un masque dur sur la couche isolante.

Selon un mode de réalisation de la présente invention, la couche de silicium amorphe est dopée du même type de conductivité que la couche de silicium.

Selon un mode de réalisation de la présente invention, le matériau réfléchissant est un métal.

Selon un mode de réalisation de la présente invention, chaque région d'isolement est constituée au moins d'une région dopée du même type de conductivité et plus fortement dopée que la couche de silicium.

Selon un mode de réalisation de la présente invention, la couche de silicium a une épaisseur comprise entre 2 et 5 µm.

Un mode de réalisation de la présente invention prévoit en outre un capteur d'images éclairé par la face arrière, comprenant une couche de silicium sur une première face de laquelle sont formés des composants de capture et de transfert de porteurs photo-générés et des régions d'isolement des composants, la couche de silicium étant destinée à être éclairée par une seconde face, comprenant en outre des tranchées partant de la seconde face et pénétrant dans les régions d'isolement, les parois des tranchées étant recouvertes d'une couche de silicium monocristallin dopée du même type de conductivité et plus fortement dopée que la couche de silicium, les tranchées étant remplies d'un matériau réfléchissant.

Selon un mode de réalisation de la présente invention, la seconde face de la couche de silicium est recouverte d'une couche d'oxyde thermique.

Selon un mode de réalisation de la présente invention, la première face de la couche de silicium est recouverte d'un empilement de niveaux d'interconnexion et d'une poignée semiconductrice.

### Brève description des dessins

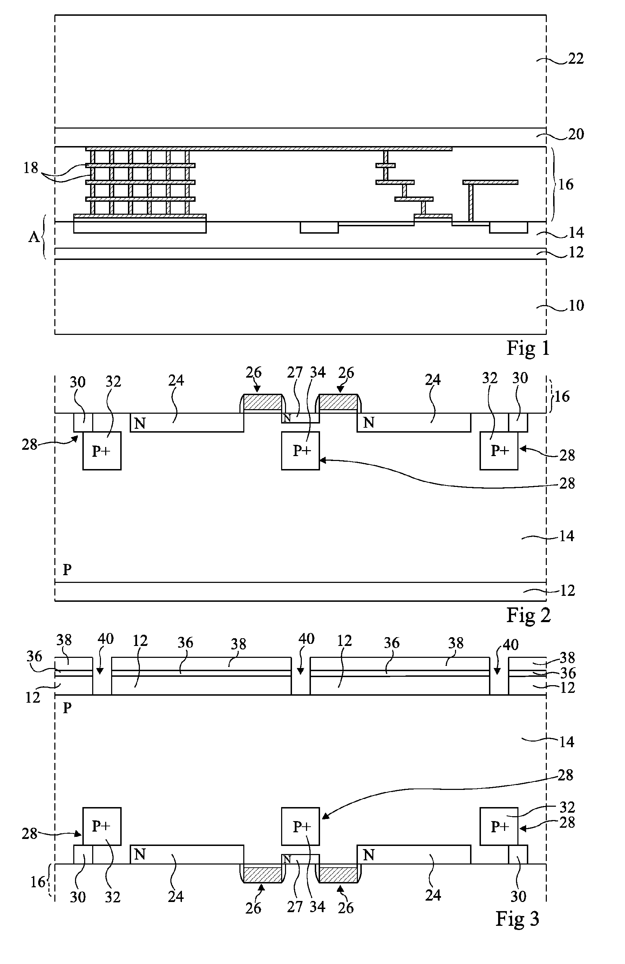

Ces objets, caractéristiques et avantages, ainsi que d'autres seront exposés en détail dans la description suivante de modes de réalisation particuliers faite à titre non-limitatif en relation avec les figures jointes parmi lesquelles les figures 1 à 9 illustrent des résultats d'étapes successives d'un procédé selon un mode de réalisation de la présente invention.

Par souci de clarté, de mêmes éléments ont été désignés par de mêmes références aux différentes figures et, de plus, comme cela est habituel dans la représentation des capteurs d'images intégrés, les diverses figures ne sont pas tracées à l'échelle.

### Description détaillée

Pour limiter les phénomènes de diaphotie dans les capteurs d'images éclairés par la face arrière, les inventeurs prévoient d'isoler complètement les régions d'absorption de photons les unes des autres en formant, sur toute l'épaisseur de la couche semiconductrice dans laquelle sont photo-générés des porteurs, des tranchées formant barrière aux déplacements de photons et de porteurs photo-générés.

Les figures 1 à 9 illustrent des résultats d'étapes successives d'un procédé selon un mode de réalisation de la présente invention.

A une étape initiale illustrée en figure 1, on part d'une structure comprenant un support ou substrat semiconducteur 10 en surface duquel est formée une couche isolante 12, la couche isolante étant revêtue d'une couche de silicium monocristallin 14 (structure de type semiconducteur sur isolant, SOI). La couche de silicium 14 présente par exemple une épaisseur comprise entre 2 et 5 µm pour détecter un maximum de rayons lumineux du domaine visible. La couche 14 peut être dopée à une concentration de dopants comprise entre 10¹⁵ et 5.10¹⁶ at/cm³. Dans et sur la couche de silicium 14 sont formées des régions de capture de porteurs photo-générés et des composants de transfert de charges qui seront décrits plus en détail ci-après. Sur la couche de silicium 14 est formé un empilement de niveaux d'interconnexion 16 comprenant des pistes et vias conducteurs 18 isolés entre eux. En surface de l'empilement d'interconnexion 16 est formée une couche isolante 20, par exemple en oxyde, sur laquelle est fixée un support ou poignée semiconductrice 22. Dans la partie gauche de l'empilement d'interconnexion 16 de la figure 1 est représenté un exemple de structure permettant la formation d'un contact sur la face arrière de la couche 14. On notera que l'invention s'applique à toute structure formée dans l'empilement d'interconnexion.

Cette structure peut être obtenue, à partir d'une structure initiale de type SOI, en réalisant les étapes suivantes : épitaxier une couche de silicium pour former une couche de silicium d'épaisseur désirée sur la structure SOI ; former des composants électroniques de transfert et des régions de capture de porteurs dans et sur la couche de silicium ; former un empilement d'interconnexion sur la structure ; et fixer une poignée sur l'empilement d'interconnexion. Ces étapes de procédé étant connues par ailleurs, elles ne seront pas décrites ici plus en détail. On notera que la couche de silicium 14 pourra être graduellement dopée.

Dans la suite de la description, les étapes du procédé seront décrites en ne considérant qu'une région limitée A de la structure de la figure 1, comprenant la couche isolante 12, la couche de silicium 14 et les composants formés dans et sur la couche 14. Ainsi, la portion située au-dessus de la couche de silicium 14 (empilement d'interconnexion 16 et poignée 22) ne sera pas représentée dans les figures suivantes, cette portion n'évoluant plus par la suite.

En figure 2 est représentée la partie A de la structure de la figure 1 après avoir éliminé le support semiconducteur 10, par exemple par une étape de meulage et/ou de gravure sélective par rapport à la couche isolante 12. La portion A comporte ainsi un empilement d'une couche isolante 12, d'une couche de silicium 14 et de niveaux d'interconnexion 16 (non représentés). Dans l'exemple de la figure 2, divers composants et régions dopées ont été représentés dans et sur la couche de silicium 14. Des régions de capture des charges photogénérées 24, en figure 2 des régions de capture d'électrons dopées de type N, sont formées dans la couche de silicium 14, la couche 14 étant dopée de type P. A titre d'exemple, les régions 24 peuvent être dopées à une concentration de dopants comprise entre 10¹⁸ et 10²⁰ at/cm³. Des systèmes de transfert des charges photo-générées, par exemple des transistors MOS 26, sont formés en surface de la couche de silicium 14. Des zones 27, dopées de type N et permettant la lecture des charges photo-générées, peuvent également être formées en surface de la couche de silicium 14. On notera que ces éléments peuvent être positionnés différemment de la façon représentée dans les figures, et que les régions de capture, de transfert et de lecture de porteurs photo-générés pourront être de tout type connu.

Des régions d'isolement 28 des pixels sont prévues autour de chaque pixel du capteur d'images. On notera que ces régions d'isolement pourront être formées autour de chaque ensemble constitué d'une région de capture de porteurs photo-générés et d'un élément de transfert de charges, ou encore autour de chaque région de capture si les éléments de transfert de charges sont communs à plusieurs régions de capture. Les régions d'isolement peuvent être de différents types.

Dans un premier cas, la région d'isolement 28 comprend une première région 30 appelée isolement par tranchée peu profonde (STI, Shallow Trench Isolation), généralement en oxyde, formée en surface de la couche 14, et une région 32 fortement dopée de type P. Par exemple, la région 32 peut être formée sous la région 30 ou encore, comme cela est représenté, légèrement en décalage avec la région 30. La région 32 pourra également s'étendre jusqu'à contacter les régions de capture de charges photogénérées 24 et/ou jusqu'à la surface de la couche 14. La région 32 peut s'étendre jusqu'à une profondeur de 1 µm dans la couche 14.

Dans un deuxième cas, la région d'isolement 28 est constituée d'une unique région 34 fortement dopée de type P s'étendant verticalement dans la couche 14, par exemple jusqu'à une profondeur de 1 µm. Dans l'exemple représenté, la région 34 s'étend sous la zone de lecture de charges 27, celle-ci étant commune à deux transistors MOS de transfert 26. Des régions d'isolement 28 comprenant une unique région 34 pourront également être prévues autour de régions de capture de porteurs 24.

La formation des régions dopées 32 et 34 peut être avantageusement réalisée avec une énergie d'implantation peu élevée. Les régions 32 et 34 pourront présenter une largeur en surface de la couche 14 de l'ordre de 0,4 µm et être dopées à une concentration de dopants comprise entre 10¹⁸ et 10²⁰ at/cm³. On notera que l'invention s'applique également à d'autres structures d'isolement en surface de pixels de capteurs d'images.

Les diverses structures d'isolement connues permettent d'atténuer la diaphotie entre les pixels. Cependant, elles ne l'annulent pas, des photons ou des porteurs photo-générés étant susceptibles de circuler dans la couche 14 sous ces structures.

A l'étape illustrée en figure 3, le dispositif a été retourné pour travailler sur la face arrière de la couche de silicium 14 (à l'opposé de la poignée 22). Sur la couche isolante 12 est formé un masque dur isolant, par exemple comprenant un empilement d'une couche 36 en nitrure de silicium présentant une épaisseur comprise entre 40 et 60 nm, par exemple de 50 nm, et d'une couche 38 de tétraéthyl orthosilicate (TEOS) ou d'oxyde de silicium présentant une épaisseur comprise entre 200 et 400 nm, par exemple de 300 nm. On notera que l'épaisseur de ces couches n'est pas limitative. A titre d'exemple, l'empilement 36/38 pourra être formé par un dépôt sous plasma (PECVD). Un tel dépôt sera de préférence réalisé à une température inférieure à 400°C pour éviter la dégradation des composants et pistes et vias conducteurs formés dans et sur la couche 14.

Un masque en résine (non représenté) est ensuite formé sur l'empilement 36/38. Des ouvertures sont formées dans le masque en résine en regard des régions d'isolement de pixels 28. A l'aide du masque de résine, on définit par gravure des ouvertures 40 dans l'empilement isolant formé des couches 12, 36 et 38. Cette gravure peut être une gravure chimique sous oxygène à base d'argon et/ou d'hexafluorobutadiène (C₄F₆), d'octafluorobutène (C₄F₈) ou de tétrafluorométhane (CF₄). Ainsi, les ouvertures 40 sont situées en regard des régions d'isolement 28. Les ouvertures 40 peuvent présenter des dimensions en surface de la couche de silicium 14 comprises entre 0,1 µm et 0,3 µm.

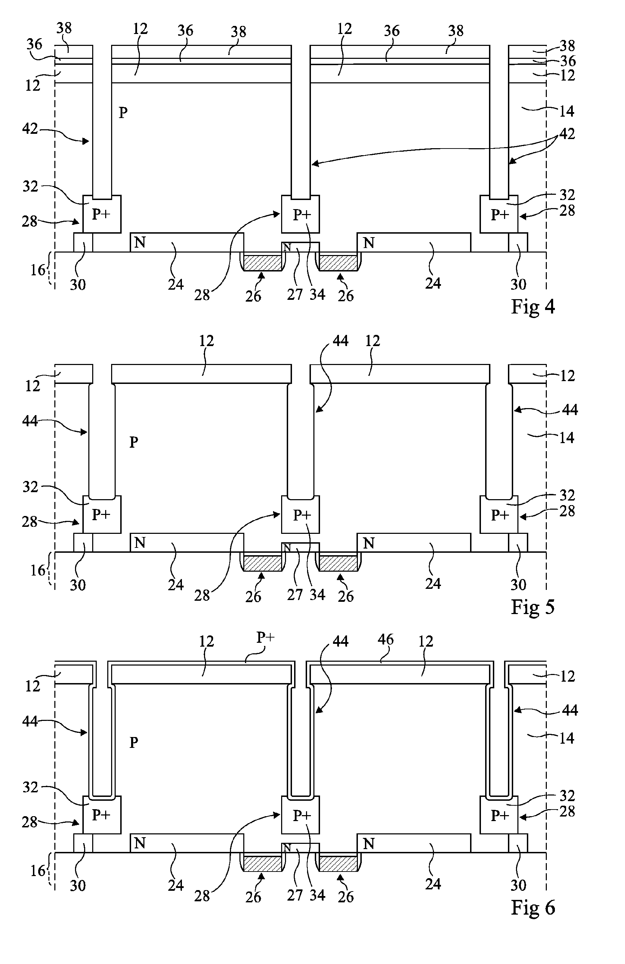

A l'étape illustrée en figure 4, on a gravé la couche de silicium 14 en regard des ouvertures 40 pour former des tranchées 42. Les tranchées 42 traversent la couche 14 et atteignent les régions d'isolement de pixels 28. Les tranchées 42 pénètrent jusqu'aux régions d'isolement de pixels 28 de façon à isoler complètement les régions de photogénération les unes des autres. A titre d'exemple, cette gravure peut être une gravure sèche réalisée sous oxygène, par exemple à l'aide de bromure d'hydrogène et/ou d'hexafluorure de soufre. Cette gravure a l'avantage de former des tranchées 42 présentant un profil bien droit et d'être sélective par rapport à l'empilement 12, 36, 38. Les tranchées 42 ont une largeur comprise entre 0,1 et 0,3 µm sur toute leur profondeur, par exemple de 0,2 µm. En effet, les procédés de gravure sèche permettent des ratios de gravure (rapport entre profondeur gravée et dispersion en largeur) élevés, typiquement supérieurs à 15. On notera qu'un léger évasement des tranchées 42, sans conséquence néfaste pour la suite du déroulement du procédé, pourra apparaître en surface de la couche 14.

A l'étape illustrée en figure 5, on a éliminé la couche d'oxyde 38, par exemple par une gravure sèche par plasma, et la couche isolante en nitrure de silicium 36, par exemple par une gravure sèche à l'aide d'hydrogène et de CHF₃, CHF₂, CH₃F ou encore H₃PO₄. Ensuite, on a réalisé un nettoyage chimique des tranchées 42, par exemple à l'aide d'une solution d'hydroxyde de tétraméthylammonium (TMAH) ou encore d'hexafluorure de soufre (SF₆). Ce nettoyage permet d'obtenir des tranchées 44 dont les parois sont bien lisses et dépourvues de défauts qui auraient pu être générés à proximité de la surface par la gravure. En effet, les parois des tranchées 42, formées par gravure sèche, ne sont pas parfaitement lisses et contiennent des défauts en surface, ou proche de la surface, ce qui peut provoquer l'apparition de courants d'obscurité indésirables. Ce lissage implique un léger agrandissement des tranchées 42. Les parois des tranchées 44 sont ainsi éloignées de 5 à 15 nm des parois des tranchées 42.

A l'étape illustrée en figure 6, on a formé, sur l'ensemble de la face arrière de la structure, à savoir sur la couche isolante 12 et sur les parois et le fond des tranchées 44, une couche de silicium amorphe 46 dopée de type P, dans notre cas du même type de conductivité que la couche de silicium 14, plus fortement dopée que cette couche 14 (par exemple à une concentration de dopants comprise entre 10¹⁹ et 10²⁰ at./cm³). Par exemple, la couche de silicium amorphe peut être formée par un dépôt de tribosilane, à environ 400°. Une cristallisation de la couche de silicium amorphe 46 est ensuite réalisée. Cette cristallisation peut être réalisée par un recuit à 450°, dans la même machine que celle servant au dépôt de silicium amorphe. La cristallisation de la couche de silicium amorphe 46 pourra également être obtenue par d'autres procédés connus de l'homme du métier, par exemple par un traitement laser localisé, un recuit rapide (par exemple de type "RTA", Rapid Thermal Annealing) ou tout autre procédé adapté.

La cristallisation de la couche de silicium amorphe 46 permet la formation, sur les parois des tranchées 44, d'une fine couche de silicium monocristallin dopé et, sur la couche isolante 12, d'une fine couche de silicium amorphe légèrement polycristallin.

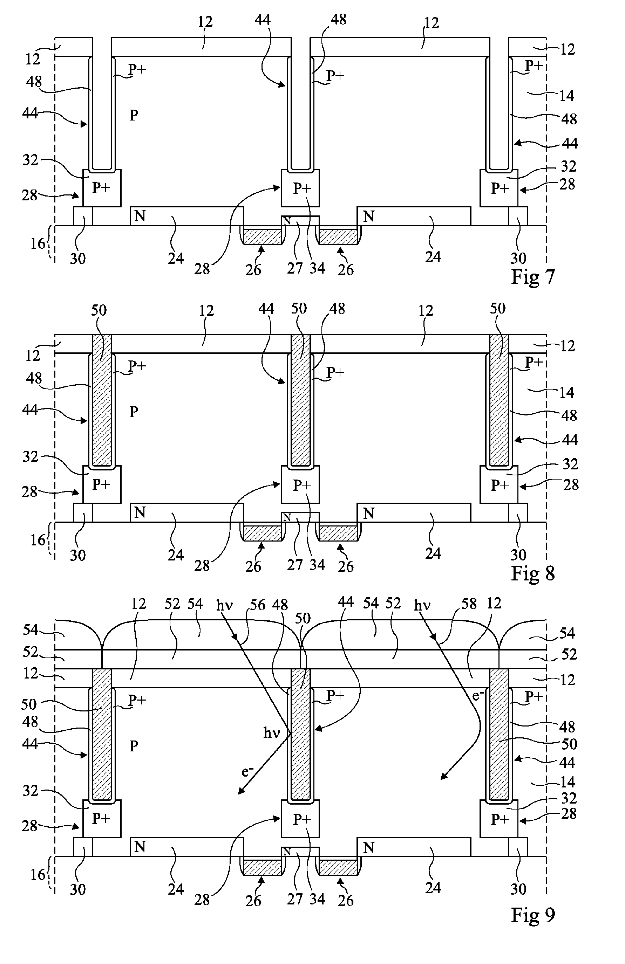

A l'étape illustrée en figure 7, le silicium amorphe légèrement polycristallin formé sur la couche isolante 12 a été éliminé, par exemple par une gravure à l'aide d'acide chlorhydrique en phase gazeuse. Il ne reste alors de la couche initiale de silicium amorphe 26 qu'une couche 48 de silicium monocristallin s'étendant sur les parois et le fond des tranchées 44.

A l'étape illustrée en figure 8, on a déposé un métal ou un matériau réfléchissant 50 de façon à remplir les tranchées 44. A titre d'exemple, le matériau 50 peut être de l'aluminium déposé à une température avoisinant les 200°C, ou encore un empilement de titane et de nitrure de titane. Le métal ou matériau réfléchissant éventuellement formé sur la couche isolante 12 est ensuite éliminé par gravure, par exemple par une gravure sèche au BCl₃ si le métal est en un alliage de titane, ou encore par un polissage mécano-chimique (CMP). On notera qu'une fine couche d'oxyde, d'épaisseur comprise entre 1 et 20 nm, pourra être formée si désiré sur les parois et le fond des tranchées 44 avant le remplissage de celles-ci par le matériau 50.

A l'étape illustrée en figure 9, on a formé, sur la couche isolante 12, des éléments classiques des détecteurs d'images, dans l'exemple représenté des filtres colorés 52 sur lesquels s'étendent des microlentilles 54. On notera que tout autre élément classique des photodétecteurs pourra être formé sur la couche 12, par exemple une couche antireflet en un nitrure.

En figure 9 sont représentés deux rayons lumineux de longueurs d'onde différentes atteignant la surface du capteur d'images dans le cas où la couche de silicium 14 est dopée de type P.

Un premier rayon ou photon (hν) 56 atteint la surface du capteur avec une incidence non nulle et se déplace dans la couche de silicium 14 jusqu'à atteindre une tranchée 44. Le matériau 50 présent dans les tranchées 44 joue le rôle de miroir pour le photon 56 et celui-ci est réfléchi vers la région de capture de porteurs 24. Le photon 56 réfléchi génère ensuite une paire électron/trou, l'électron (e⁻) étant attiré et capturé par la région 24.

Un deuxième rayon ou photon (hν) 58, de longueur d'onde inférieure à celle du premier rayon 56, atteint la surface du capteur avec une incidence non nulle et génère une paire électron/trou dès son entrée dans la couche de silicium 14. L'électron (e⁻) issu de ce photon se déplace ensuite en direction d'une tranchée 44. La présence de la couche monocristalline fortement dopée 48 et sa différence de dopage avec la couche de silicium 14 crée un champ électrique qui repousse l'électron vers le centre du pixel. L'électron atteint ainsi la région de collecte 24.

Ainsi, les tranchées 44 jouent un double rôle. La présence de la couche fortement dopée 48 permet de repousser les électrons vers la région de capture et la présence du matériau réfléchissant dans les tranchées 44 permet la réflexion des photons incidents. Ainsi, quelque soit la longueur d'onde d'un rayon incident, la paire électron/trou qu'il va générer dans la couche de silicium 14 sera détectée par la cellule photodétectrice associée. Les tranchées 44 permettent donc d'éviter tout phénomène de diaphotie entre les pixels, que ce soit par diaphotie optique (passage d'un photon vers une cellule photodétectrice voisine) ou par diaphotie électronique (passage d'un porteur, électron ou trou, vers une cellule photodétectrice voisine).

De plus, avantageusement, les tranchées 44 ont des dimensions en surface de la couche 14 relativement faibles, ce qui permet un rapport surface utile sur surface totale de chaque pixel élevé.

Enfin, l'interface entre la couche isolante 12 et la couche de silicium 14 est de bonne qualité, la couche isolante 12 étant généralement une couche d'oxyde thermique. En effet, dans les procédés de formation de structure de type semiconducteur sur isolant, la couche isolante intermédiaire est formée par une oxydation thermique de la surface du support semiconducteur. L'interface entre oxyde et semiconducteur est alors de bonne qualité, ce qui permet d'éviter les phénomènes de génération de courants d'obscurité à l'interface entre oxyde et semiconducteur.

Des modes de réalisation particuliers de la présente invention ont été décrits. Diverses variantes et modifications apparaîtront à l'homme de l'art. En particulier, on notera que les types de conductivité des différentes régions dopées présentés ici pourront être inversés, la capture dans les régions 24 étant alors une capture de trous et non pas d'électrons.

## Revendications

1. Procédé de fabrication d'un capteur d'images éclairé par la face arrière, comprenant les étapes suivante :
(a) former, dans et sur une couche de silicium (14) s'étendant sur un support semiconducteur (10) avec interposition d'une couche isolante (12), des composants électroniques de capture et de transfert de porteurs photo-générés (24, 26, 27) et des régions d'isolement desdits composants (28) ;
(b) former un empilement de niveaux d'interconnexion (16) sur la couche de silicium (14) et fixer, en surface de l'empilement d'interconnexion, une poignée semiconductrice (22) ;
(c) éliminer le support semiconducteur (10) ;
(d) former, dans la couche isolante (12) et la couche de silicium (14), des tranchées (42, 44) atteignant les régions d'isolement ;
(e) déposer une couche de silicium amorphe (46) plus fortement dopée que la couche de silicium (14) au moins sur les parois et le fond des tranchées et faire cristalliser ladite couche de silicium amorphe (48) ; et
(f) remplir les tranchées d'un matériau réfléchissant (50).

2. Procédé selon la revendication 1, dans lequel l'étape (e) est précédée d'une étape de lissage des parois des tranchées (42) à l'aide d'une solution chimique.

3. Procédé selon la revendication 1 ou 2, dans lequel l'étape (d) est précédée d'une étape de formation d'un masque dur (36, 38) sur la couche isolante (12).

4. Procédé selon l'une quelconque des revendications 1 à 3, dans lequel la couche de silicium amorphe (46) est dopée du même type de conductivité que la couche de silicium (14).

5. Procédé selon l'une quelconque des revendications 1 à 4, dans lequel le matériau réfléchissant (50) est un métal.

6. Procédé selon l'une quelconque des revendications 1 à 5, dans lequel chaque région d'isolement (28) est constituée d'au moins une région dopée (32, 34) de même type de conductivité et plus fortement dopée que la couche de silicium (14).

7. Procédé selon l'une quelconque des revendications 1 à 6, dans lequel la couche de silicium (14) a une épaisseur comprise entre 2 et 5 µm.

8. Capteur d'images éclairé par la face arrière, comprenant une couche de silicium (14) sur une première face de laquelle sont formés des composants de capture et de transfert de porteurs photo-générés (24, 26, 27) et des régions d'isolement (28) desdits composants, la couche de silicium (14) étant destinée à être éclairée par une seconde face, comprenant en outre des tranchées (44) partant de ladite seconde face et pénétrant dans les régions d'isolement, les parois desdites tranchées étant recouvertes d'une couche de silicium monocristallin (48) dopée de même type de conductivité et plus fortement dopée que la couche de silicium, les tranchées étant remplies d'un matériau réfléchissant (50).

9. Capteur d'images selon la revendication 8, dans lequel la seconde face de la couche de silicium (14) est recouverte d'une couche d'oxyde thermique (12).

10. Capteur d'images selon la revendication 8 ou 9, dans lequel la première face de la couche de silicium (14) est recouverte d'un empilement de niveaux d'interconnexion (16) et d'une poignée semiconductrice (22).
